# EUROPEAN PATENT APPLICATION

(11) **EP 4 170 357 A1**
(43) Date of publication of application: **26.04.2023**
(21) Application number: 22200055.6
(22) Date of filing: 06.10.2022
(51) Int. Cl.: G01R 1/04, G01R 31/28

(54) **CHIP TEST CARRIER**

(30) Priority: 22.10.2021 TW 110139346
(71) Applicant: G. Skill International Enterprise Co., Ltd., Taipei City 11070 (TW)
(72) Inventor: HUANG, Chiung-Huang, Taipei City, 11070 (TW)
(74) Representative: Germain Maureau

(57) **Abstract**

A chip test carrier for carrying chips includes a circuit board (1), a positioning seat (2), a chip frame (3), and a pressing cover unit (5). The positioning seat (2) includes upper and lower plates (22, 21) cooperating to clamp the circuit board (1) therebetween. The upper plate (22) includes a chip-mounting portion (221) and an engaging slot (222). The chip frame (3) is disposed on the chip-mounting portion (221), and is formed with frame slots (31) for accommodating the chips, respectively. The cover unit (5) includes a cover body (51) connected pivotably to the positioning seat (2), an engaging member (52) pivotably connected to the cover body (51) and detachably engages the engaging slot (222), and pressing blocks (53) connected to the cover body (51) and pressing respectively against the chips.

## Description

The disclosure relates to a test carrier, more particularly to a chip test carrier.

The prices of chips differ according to their respective performances, and chips with relatively good performances are usually relatively expensive. Generally, a plurality of chips are soldered on a circuit board to form a dynamic random access memory (DRAM) and thus a DRAM is usually quite expensive. If one of the chips soldered on the circuit board has a poor quality or is damaged, the DRAM may malfunction and the entire DRAM will be discarded, which causes a great loss.

Thus, it is necessary to test whether each chip can operate normally after manufacture of the chip is completed and before the chip is soldered onto a circuit board, to thereby ensure an overall quality of a DRAM. Since the size of each of the chips is quite small, the chips are required to be mounted on a carrier so as to be connected to a testing device, facilitating a test to be performed on the chips.

Therefore, an object of the disclosure is to provide a chip test carrier having a structure that allows chips to be conveniently mounted thereon and removed therefrom.

According to an aspect of the disclosure, a chip test carrier adapted to carry a plurality of chips to be tested is provided. The chip test carrier includes a circuit board, a positioning seat, a first chip frame, and a first pressing cover unit. The circuit board is rectangular, has two long sides extending along a longitudinal direction and two short sides each having a length shorter than that of each of the long sides and extending along a transverse direction transverse to the longitudinal direction, and includes an insert portion disposed on one of the long sides. The positioning seat includes an upper plate and a lower plate fixed to and cooperating with the upper plate to clamp the circuit board therebetween with the insert portion exposed outwardly. The upper plate includes a first chip-mounting portion that is rectangular, that has two long sides extending along the longitudinal direction and two short sides each having a length shorter than that of each of the long sides of the first chip-mounting portion and extending along the transverse direction, that is dented from an upper surface of the upper plate, and that includes a plurality of first connecting pads arranged along the longitudinal direction and electrically connected to the circuit board. The upper plate is formed with a first engaging slot disposed adjacent to one of the short sides of the first chip-mounting portion. The first chip frame is disposed on the first chip-mounting portion, and is formed with a plurality of first frame slots which correspond respectively in position to the first connecting pads, in which the first connecting pads are exposed respectively, and each of which is adapted to accommodate one of the chips therein. The first pressing cover unit includes a cover body, an engaging member and a plurality of pressing blocks. The cover body has a first pivotable connecting portion and a second connecting portion. The first pivotable connecting portion is connected pivotably to the positioning seat such that the cover body is pivotable relative to the positioning seat between an open position and a close position, where the cover body uncovers and covers the first chip-mounting portion, respectively. The second connecting portion is disposed opposite to the first pivotable connecting portion along the longitudinal direction when the cover body is at the close position. The engaging member is pivotably connected to the second connecting portion and detachably engages the first engaging slot so as to position the cover body at the close position when engaging the first engaging slot. The pressing blocks are connected to the cover body such that, when the cover body is at the close position, the pressing blocks correspond respectively in position to the first frame slots so as to press respectively against the chips received in the first frame slots.

Other features and advantages of the disclosure will become apparent in the following detailed description of the embodiment with reference to the accompanying drawings, of which:
FIG. 1 is a perspective view of an embodiment of a chip test carrier according to the present disclosure, illustrating that each of two cover bodies of the embodiment is at a close position;
FIG. 2 is a perspective view of the embodiment, illustrating that each of the two cover bodies is at an open position; and
FIG. 3 is an exploded perspective view of the embodiment.

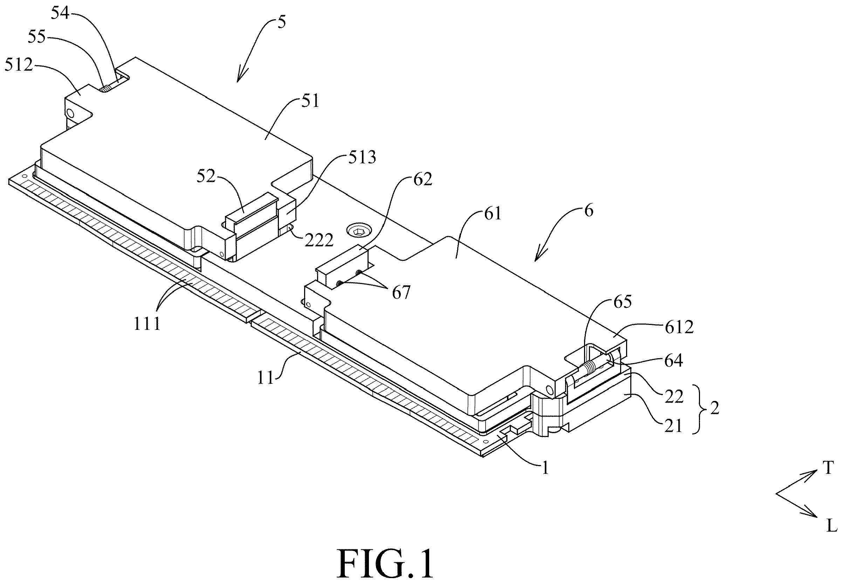

Referring to FIGS. 1 to 3, an embodiment of a chip test carrier according to the present disclosure is shown. The chip test carrier is adapted to carry a plurality of chips to be tested, and includes a circuit board 1, a positioning seat 2, a first chip frame 3, a second chip frame 4, a first pressing cover unit 5, and a second pressing cover unit 6.

The circuit board 1 is rectangular, has two long sides extending along a longitudinal direction (L) and two short sides each having a length shorter than that of each of the long sides and extending along a transverse direction (T) transverse to the longitudinal direction (L), and includes an insert portion 11 disposed on one of the long sides and including a plurality of conductive pads 111 that are adapted to be electrically connected to a card edge connector (not shown).

The positioning seat 2 includes an upper plate 22 and a lower plate 21 fixed to and cooperating with the upper plate 22 to clamp the circuit board 1 therebetween with the insert portion 11 exposed outwardly. In this embodiment, a plurality of screws 7 are employed to fixedly connect the upper plate 22 and the lower plate 21. The upper plate 22 has two long sides extending along the longitudinal direction (L) and two short sides each having a length shorter than that of each of the long sides of the upper plate 22 and extending along the transverse direction (T). The upper plate 22 includes a first chip-mounting portion 221 and a second chip-mounting portion 223 that are arranged to be spaced apart from each other along the longitudinal direction (L) and that are adjacent to the insert portion 11.

Each of the first and second chip-mounting portions 221, 223 is rectangular, has two long sides extending along the longitudinal direction (L) and two short sides each having a length shorter than that of each of the long sides of a respective one of the first and second chip-mounting portions 221, 223 and extending along the transverse direction (T), and is dented from an upper surface 220 of the upper plate 22.

The first and second chip-mounting portions 221, 223 respectively include a plurality of first and second connecting pads 225, 227 arranged along the longitudinal direction (L), electrically connected to the circuit board 1, and adapted to be connected respectively to a plurality of chips to be tested. The upper plate 22 is formed with a first engaging slot 222 disposed adjacent to one of the short sides of the first chip-mounting portion 221, and the lower plate 21 is formed with a second engaging slot 224 disposed adjacent to one of the short sides of the second chip-mounting portion 223.

The first chip frame 3 is disposed on the first chip-mounting portion 221, and is formed with a plurality of first frame slots 31 which correspond respectively in position to the first connecting pads 225, in which the first connecting pads 225 are exposed respectively, and each of which is adapted to accommodate one of the chips therein.

The second chip frame 4 is disposed on the second chip-mounting portion 223 and is formed with a plurality of second frame slots 41 which correspond respectively in position to the second connecting pads 227, in which the second connecting pads 227 are exposed respectively, and each of which is adapted to accommodate one of the chips therein.

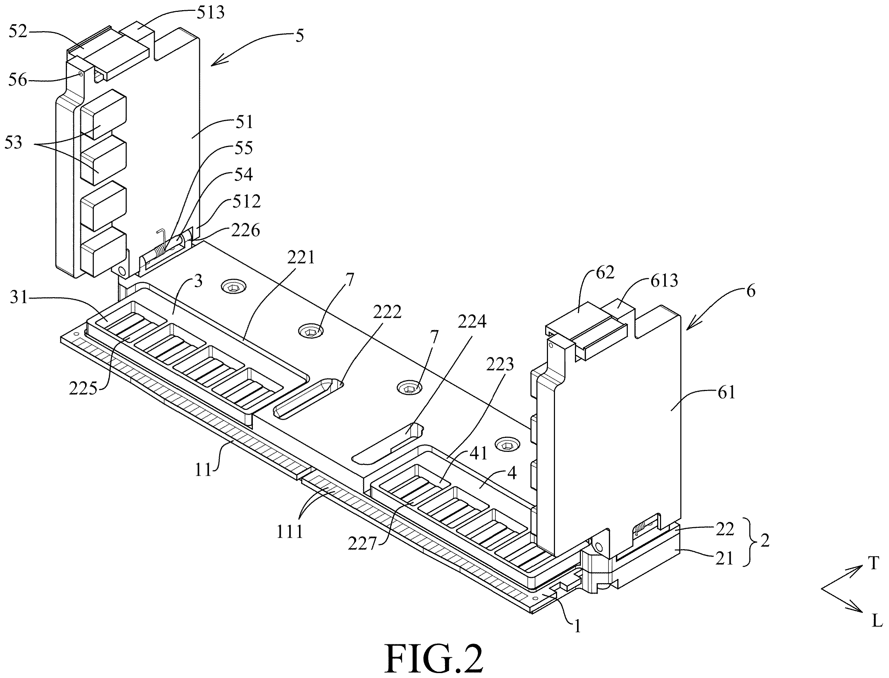

The first pressing cover unit 5 includes a cover body 51, an engaging member 52 and a plurality of pressing blocks 53. The cover body 51 has a main portion 511, a first pivotable connecting portion 512, and a second connecting portion 513. The first pivotable connecting portion 512 is connected pivotably to the positioning seat 2 such that the cover body 51 is pivotable relative to the positioning seat 2 between an open position (see FIG. 2) and a close position (see FIG. 1), where the cover body 51 uncovers and covers the first chip-mounting portion 221, respectively. The main portion 511 is rectangular and has a first longitudinal edge 511a that is disposed adjacent to one of the long sides of the upper plate 22 when the cover body 51 is at the close position, a second longitudinal edge 511b that is opposite to the first longitudinal edge 511a along the transverse direction (T), and that is disposed adjacent to the insert portion 11 when the cover body 51 is at the close position, and first and second transverse edges 511c, 511d that are transverse to and connected between the first longitudinal edge 511a and the second longitudinal edge 511b.

The first pivotable connecting portion 512 extends along the first transverse edge 511c and is disposed adjacent to the first longitudinal edge 511a. The second connecting portion 513 is disposed opposite to the first pivotable connecting portion 512 along the longitudinal direction (L) when the cover body 51 is at the close position, and extends along the second transverse edge 511d and is disposed adjacent to the second longitudinal edge 511b.

The engaging member 52 is pivotably connected to the second connecting portion 513 and detachably engages the first engaging slot 222 so as to position the cover body 51 at the close position when engaging the first engaging slot 222.

The pressing blocks 53 are connected to the cover body 51 such that, when the cover body 51 is at the close position, the pressing blocks 53 correspond respectively in position to the first frame slots 31 so as to press respectively against the chips received in the first frame slots 31.

Note that the structure of the first and second pressing cover units 5, 6 are substantially identical and the second pressing cover unit 6 includes a cover body 61, an engaging member 62 and a plurality of pressing blocks 63. The cover body 61 has a first pivotable connecting portion 612 and a second connecting portion 613. The first pivotable connecting portion 612 is connected pivotably to the positioning seat 2 such that the cover body 61 is pivotable relative to the positioning seat 2 between an open position and a close position, where the cover body 61 uncovers and covers the second chip-mounting portion 223, respectively. The second connecting portion 613 is disposed opposite to the first pivotable connecting portion 612 along the longitudinal direction (L) when the cover body 61 of the second pressing cover unit 6 is at the close position. The engaging member 62 is pivotably connected to the second connecting portion 613 of the second pressing cover unit 6 and detachably engages the second engaging slot 224 so as to position the cover body 61 at the close position when engaging the second engaging slot 224. The pressing blocks 63 are connected to the cover body 61 of the second pressing cover unit 6 such that, when the cover body 61 of the second pressing cover unit 6 is at the close position, the pressing blocks 63 of the second pressing cover unit 6 correspond respectively in position to the second frame slots 41 so as to press respectively against the chips received in the second frame slots 41.

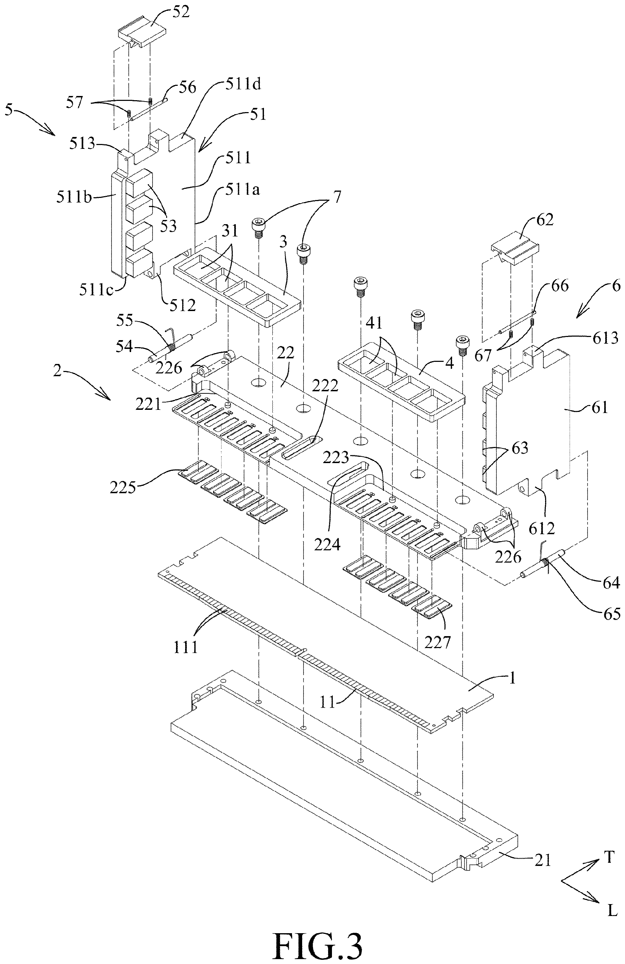

As shown in FIG. 3, the upper plate 22 has two long sides extending along the longitudinal direction (L) and two short sides each having a length shorter than that of each of the long sides of the upper plate 22 and extending along the transverse direction (T), and includes two pairs of lugs 226 spaced apart along the longitudinal direction (L) and pivotably and respectively connected to the first pivotable connecting portion 512 of the first pressing cover unit 5 and the first pivotable connecting portion 612 of the second pressing cover unit 6. Each pair of the lugs 226 are spaced apart from each other along the transverse direction (T) and protrude from the upper surface 220 of the upper plate 22. In this embodiment, the first pressing cover unit 5 further includes a pivot pin 54 extending through one pair of the lugs 226, a torsion spring 55 sleeved on the pivot pin 54 and biasing the cover body 51 to the open position (see FIG. 2) when the engaging member 52 disengages from the first engaging slot 222, a pin 56 extending through the engaging member 52 and the second connecting portion 513, and two springs 57 disposed between the engaging member 52 and the second pivot connecting portion 513 such that the engaging member 52 is biased by the springs 57 to resiliently engage the first engaging slot 222.

Similarly, the second pressing unit 6 includes a pivot pin 64 extending through the other one pair of the lugs 226, a torsion spring 65 sleeved on the pivot pin 64 and biasing the cover body 61 to the open position (see FIG. 2) when the engaging member 62 disengages from the second engaging slot 224, a pin 66 extending through the engaging member 62 and the second connecting portion 63, and two springs 67 disposed between the engaging member 62 and the second pivot connecting portion 613 such that the engaging member 62 is biased by the springs 67 to resiliently engage the second engaging slot 224.

By virtue of the structure of the first pivotable connecting portion 512 and the second connecting portion 513 that are disposed at opposite sides of the cover body 51, and the first engaging slot 222 disposed adjacent to one of the short sides of the first chip-mounting portion 221, it is relatively simple for a user to operate the engaging member 52 to close and open the cover body 51.

Further, since the engaging position and the pivot connection position between the cover body 51 and the positioning seat 2 are respectively adjacent to two ends of the first chip-mounting portion 221 along the longitudinal direction (L), the pressing blocks 53 can press respectively and firmly against the chips received in the first frame slots 31, so that the stability of electrical connection between each of the chips and the circuit board 1 can be increased. Since the configuration of the second pressing cover unit 6 is identical to that of the first pressing cover unit 5, further details of the same are omitted for the sake of the brevity.

Note that in this embodiment, the first and second pressing cover units 5, 6 are operated to pivot relative to the positioning seat 2 in different directions, but the position of each of the first and second pressing cover units 5, 6 relative to the positioning seat 2 may be modified in such a manner that the first and second pressing cover units 5, 6 are operated in the same direction. That is to say, the first and second engaging slots 222, 224 are formed to be spaced apart from each other by either one of the first and second chip-mounting portions 221, 223. In other embodiments, the second pressing cover unit 6 can be omitted.

To sum up, by virtue of the structural relationship between the positioning seat 2 and each of the cover bodies 51, 61 of the first and second pressing cover units 5, 6, it is relatively simple to operate the engaging members 52, 62 to move the cover bodies 51, 61 between the open and close positions to thereby mount and remove the chips to and from the chip test carrier of the present disclosure. Further, the pressing blocks 53, 63 press firmly and respectively against the chips received in the first and second frame slots 31, 41 provide relatively good stability of electrical connection between each of the chips and the circuit board 1.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A chip test carrier adapted to carry a plurality of chips to be tested, comprising:
a circuit board (1) that is rectangular, that has two long sides extending along a longitudinal direction (L) and two short sides each having a length shorter than that of each of said long sides and extending along a transverse direction (T) transverse to the longitudinal direction (L), and that includes an insert portion (11) disposed on one of said long sides; said chip test carrier being **characterized by**:
a positioning seat (2) that includes an upper plate (22) and a lower plate (21) fixed to and cooperating with said upper plate (22) to clamp said circuit board (1) therebetween with said insert portion (11) exposed outwardly, said upper plate (22) including a first chip-mounting portion (221) that is rectangular, that has two long sides extending along the longitudinal direction (L) and two short sides each having a length shorter than that of each of said long sides of said first chip-mounting portion (221) and extending along the transverse direction (T), that is dented from an upper surface (220) of said upper plate (22), and that includes a plurality of first connecting pads (225) arranged along the longitudinal direction (L) and electrically connected to said circuit board (1), said upper plate (22) being formed with a first engaging slot (222) disposed adjacent to one of said short sides of said first chip-mounting portion (221);
a first chip frame (3) that is disposed on said first chip-mounting portion (221), and that is formed with a plurality of first frame slots (31) which correspond respectively in position to said first connecting pads (225), in which said first connecting pads (225) are exposed respectively, and each of which is adapted to accommodate one of the chips therein; and
a first pressing cover unit (5) that includes
a cover body (51) having:
a first pivotable connecting portion (512) connected pivotably to said positioning seat (2) such that said cover body (51) is pivotable relative to said positioning seat (2) between an open position and a close position, where said cover body (51) uncovers and covers said first chip-mounting portion (221), respectively; and
a second connecting portion (513) disposed opposite to said first pivotable connecting portion (512) along the longitudinal direction (L) when said cover body (51) is at the close position,
an engaging member (52) pivotably connected to said second connecting portion (513) and detachably engaging said first engaging slot (222) so as to position said cover body (51) at the close position when engaging said first engaging slot (222), and
a plurality of pressing blocks (53) connected to said cover body (51) such that, when said cover body (51) is at the close position, said pressing blocks (53) correspond respectively in position to said first frame slots (31) so as to press respectively against the chips received in said first frame slots (31).

2. The chip test carrier as claimed in Claim 1, **characterized in that** said upper plate (22) includes a pair of lugs (226) and has two long sides extending along the longitudinal direction (L) and two short sides each having a length shorter than that of each of said long sides of said upper plate (22) and extending along the transverse direction (T), said lugs (226) being spaced apart from each other along the transverse direction (T), protruding from said upper surface (220) of said upper plate (22) and being pivotably connected to said first pivotable connecting portion (512).

3. The chip test carrier as claimed in Claim 1, **characterized in that** said upper plate (22) further includes a second chip-mounting portion (223) that is rectangular, that has two long sides extending along the longitudinal direction (L) and two short sides each having a length shorter than that of each of said long sides of said second chip-mounting portion (223) and extending along the transverse direction (T), that is dented from said upper surface (220) of said upper plate (22), and that includes a plurality of second connecting pads (227) arranged along the longitudinal direction (L) and electrically connected to said circuit board (1), said second chip-mounting portion (223) and said first chip-mounting portion (221) being arranged to be spaced apart from each other along the longitudinal direction (L) and being adjacent to said insert portion (11), said upper plate (22) being further formed with a second engaging slot (224) disposed adjacent to one of said short sides of said second chip-mounting portion (223), said chip test carrier further comprising:
a second chip frame (4) that is disposed on said second chip-mounting portion (223) and that is formed with a plurality of second frame slots (41) which correspond respectively in position to said second connecting pads (227), in which said second connecting pads (227) are exposed respectively, and each of which is adapted to accommodate one of the chips therein; and
a second pressing cover unit (6) that includes
a cover body (61) having:
a first pivotable connecting portion (612) connected pivotably to said positioning seat (2) such that said cover body (61) of said second pressing cover unit (6) is pivotable relative to said positioning seat (2) between an open position and a close position, where said cover body (61) of said second pressing cover unit (6) uncovers and covers said second chip-mounting portion (223), respectively; and
a second connecting portion (613) disposed opposite to said first pivotable connecting portion (612) of said second pressing cover unit (6) along the longitudinal direction (L) when said cover body (61) of said second pressing cover unit (6) is at the close position,
an engaging member (62) pivotably connected to said second connecting portion (613) of said second pressing cover unit (6) and detachably engaging said second engaging slot (224) so as to position said cover body (61) of said second pressing cover unit (6) at the close position when engaging said second engaging slot (224), and
a plurality of pressing blocks (63) connected to said cover body (61) of said second pressing cover unit (6) such that, when said cover body (61) of said second pressing cover unit (6) is at the close position, said pressing blocks (63) of said second pressing cover unit (6) correspond respectively in position to said second frame slots (41) so as to press respectively against the chips received in said second frame slots (41).

4. The chip test carrier as claimed in Claim 3, **characterized in that** said upper plate (22) includes two pairs of lugs (226) spaced apart along the longitudinal direction (L) and pivotably and respectively connected to said first pivotable connecting portion (512) of said first pressing cover unit (5) and said first pivotable connecting portion (612) of said second pressing cover unit (6), each pair of said lugs (226) being spaced apart from each other along the transverse direction (T) and protruding from said upper surface (220) of said upper plate (22).

5. The chip test carrier as claimed in Claim 4, **characterized in that** said upper plate (22) has two long sides extending along the longitudinal direction (L) and two short sides each having a length shorter than that of each of said long sides of said upper plate (22) and extending along the transverse direction (T), the two pairs of said lugs (226) being disposed respectively adjacent to said short sides of said upper plate (22), said first engaging slot (222) and said second engaging slot (224) being disposed between and adjacent to said first chip-mounting portion (221) and said second chip-mounting portion (223).

6. The chip test carrier as claimed in any one of Claims 1 to 5, **characterized in that** said upper plate (22) has two long sides extending along the longitudinal direction (L) and two short sides each having a length shorter than that of each of said long sides of said upper plate (22) and extending along the transverse direction (T), said cover body (51) further including a main portion (511) being rectangular and having a first longitudinal edge (511a) that is disposed adjacent to one of said long sides of said upper plate (22) when said cover body (51) is at the close position, a second longitudinal edge (511b) that is opposite to said first longitudinal edge (511a) along the transverse direction (T), and that is disposed adjacent to said insert portion (11) when said cover body (51) is at the close position, and first and second transverse edges (511c, 511d) that are transverse to and connected between said first longitudinal edge (511a) and said second longitudinal edge (511b), said first pivotable connecting portion (512) extending along said first transverse edge (511c) and being disposed adjacent to said first longitudinal edge (511a), said second connecting portion (513) extending along said second transverse edge (511d) and being disposed adjacent to said second longitudinal edge (511b).

7. The chip test carrier as claimed in any one of Claims 1 to 6, **characterized in that** said first pressing cover unit (5) further includes two springs (57) disposed between said engaging member (52) and said second pivot connecting portion (513) such that said engaging member (52) is biased by said springs (57) to resiliently engage said first engaging slot (222) .
